# FASCICULE DE BREVET EUROPEEN

(11) **EP 3 513 120 B1**
(45) Date de publication et mention de la délivrance du brevet: **03.09.2025**
(21) Numéro de dépôt: 17746141.5
(22) Date de dépôt: 04.08.2017
(51) Int. Cl.: F21V 23/00, B60Q 1/04, H01L 23/00, H05K 1/02, H05K 3/46, H01L 25/075, F21Y 105/10, B60Q 1/00, F21S 41/153, F21S 41/19, F21S 41/663, F21Y 115/10

(54) **CÂBLAGE D'UNE SOURCE LUMINEUSE DE HAUTE RÉSOLUTION**
VERKABELUNG EINER HOCHAUFLÖSENDEN LICHTQUELLE
CABLING OF A HIGH RESOLUTION LIGHT SOURCE

(30) Priorité: 15.09.2016 FR 1658663
(43) Date de publication de la demande: 24.07.2019
(73) Titulaire: Valeo Vision, 93012 Bobigny Cedex (FR)
(72) Inventeur: LEFAUDEUX, Nicolas, 93012 Bobigny Cedex (FR); DE LAMBERTERIE, Antoine, 93012 Bobigny Cedex (FR); THIN, Guillaume, 93012 Bobigny Cedex (FR); MBATA, Samira, 93012 Bobigny Cedex (FR); CANONNE, Thomas, 93012 Bobigny Cedex (FR); HOANG, Van-Thai, 93012 Bobigny Cedex (FR); DUBOIS, Vincent, 93012 Bobigny Cedex (FR); AMIEL, François-Xavier, 93012 Bobigny Cedex (FR)
(74) Mandataire: Valeo Visibility
(86) Numéro de dépôt international: PCT/EP2017/069846
(87) Numéro de publication internationale: WO 2018/050355

(56) Documents cités:
- EP-A1- 2 838 117
- WO-A1-2010/014032
- DE-A1- 102011 017 790
- DE-A1- 102011 079 473
- DE-U1- 202004 003 793

## Description

### DOMAINE DE L'INVENTION

L'invention se rapporte au domaine des modules lumineux de véhicule terrestre, c'est-à-dire des modules pouvant être intégrés à un dispositif lumineux du véhicule et permettant, lors de l'utilisation du véhicule, de projeter de la lumière éclairant la route ou l'habitacle et/ou permettant au véhicule de se rendre plus visible. Des exemples de tels dispositifs lumineux sont les feux de position ou les feux de croisement et/ou route (communément appelés « phares »).

### ARRIERE-PLAN

Un véhicule terrestre est équipé de dispositifs lumineux, notamment d'éclairage et/ou de signalisation, tels que des projecteurs avants ou feux arrières, destinés à illuminer la route devant le véhicule, la nuit ou en cas de luminosité réduite. Ils peuvent aussi servir à éclairer l'habitacle du véhicule. Ces dispositifs lumineux peuvent comprendre un ou plusieurs modules lumineux. Chaque fonction d'éclairage peut être assurée par un ou des module(s).

Dans ces modules lumineux de véhicules terrestres, des sources de lumière électroluminescente sont de plus en plus fréquemment utilisées. Ces sources lumineuses peuvent constituées par des diodes électroluminescentes ou LEDs (acronyme anglais pour « Light Emitting Diode »), par des diodes électroluminescentes organiques ou OLEDs (acronymes anglais pour « organic light-emitting diodes », ou encore par des diodes électroluminescentes polymériques ou PLED (acronymes anglais pour « polymer light-emitting diodes »). Ces sources lumineuses offrent notamment des avantages d'encombrement et de durée de vie par rapport à des sources de lumière classiques telles que par exemple les ampoules à filament.

L'utilisation de ces nouvelles sources lumineuse offre de nouvelles perspectives dans l'amélioration des éclairages fournis par les dispositifs lumineux d'un véhicule. Notamment, l'utilisation de matrices monolithique de LEDs (ou encore monolithic array of LEDs en anglais) permettent de sélectionner avec une très grande précisions quelles sont les zones d'une scène qui sont éclairées, et avec quelle intensité lumineuse. Une matrice monolithique comprend des centaines ou des milliers de DELs qui sont situées sur un même substrat, les DELs étant séparées des autres par des lignes (ou encore « lanes » en anglais) ou des rues (ou encore « streets » en anglais). Dans ce contexte de matrice monolithique, les DELs sont également appelées pixels. Cependant, chacune des DELs est indépendante électriquement des autres et éclaire donc de manière autonome des autres DEL de la matrice. Pour ce faire, chaque DEL de la matrice est commandée individuellement par le circuit électronique qui gère son alimentation électrique (circuit appelé « driver » en anglais), ce qui implique que plus la densité de DELs est importante, plus le nombre de fils pour alimenter électriquement les DELs est importants.

Afin de rendre faisable le câblage de l'alimentation électrique des DELs d'une matrice, on connait la technique dite de l'empilement (ou encore « stacking » en anglais) qui consiste à empiler la matrice de LED avec le circuit qui gère son alimentation électrique (ou encore « driver » en anglais). Or il existe de nombreuses contraintes techniques qui limitent la faisabilité de tels empilements. Tout d'abord, la dissipation thermique est dégradée du fait même de l'empilement de la matrice de DELs avec son driver. Ceci est un problème important puisque la chaleur générée par les DELs entraîne une élévation de la température au niveau des composants qui peut dégrader les composants et/ou en empêcher une utilisation optimale. En outre, le driver génère lui-même de la chaleur et peut être détruit par la chaleur produite les DELs. Ensuite, il y a des contraintes sur la géométrie du driver qui est généralement implémenté sur un ASIC (acronyme de l'anglais « Application-Specific Integrated Circuit »). En effet, les dimensions standardisées de l'ASIC doivent correspondre à celles de la matrice qui obéissent à d'autres standards afin d'obtenir un module lumineux de la plus petites taille possible. Or les standards actuels n'offrent pas de correspondances entre ces différentes dimensions de sorte que les différences de tailles entre le drive et la matrice de DEL sont trop importantes.

Il existe des documents antérieurs décrivant des améliorations dans le domaine des dispositifs d'éclairage LED, avec un accent particulier mis sur l'optimisation de leur efficacité à travers différentes approches techniques telles que le contrôle de l'alimentation, la gestion thermique, la nanostructuration et l'intégration des composants. A titre d'exemple :
- Le document DE 102011079473 A1 décrit un module d'éclairage comprenant au moins deux chaînes de LED avec un système de contrôle pour réguler l'énergie d'alimentation et contrôler les chaînes de LED individuelles via des éléments de commutation et des signaux PWM ;
- Le document EP 2838117 A1 décrit un dispositif d'éclairage LED avec un circuit imprimé ayant un substrat thermiquement conducteur, des électrodes et un corps encapsulé formé intégralement pour couvrir les puces LED et les composants électroniques ;
- Le document WO 2010/014032 A1 décrit un dispositif LED nanostructuré comprenant des nanofils avec des jonctions p-i-n, où les nanofils dépassent d'un substrat et ont une couche de contact réfléchissante avec des plots de contact distribués pour une meilleure efficacité et un contrôle individuel ;
- Le document DE 102011017790 A1 décrit un dispositif d'éclairage et une méthode de fabrication comprenant au moins une source LED et une plaque conductrice avec au moins un élément de construction intégré dans la plaque conductrice ;
- Le document DE 202004003793 U1 décrit un arrangement LED spécifiquement conçu pour être installés dans les véhicules comprenant des LED, des composants électroniques pour l'alimentation électrique et un corps de refroidissement avec des propriétés de blindage électromagnétique.

### RESUME DE L'INVENTION

On propose pour cela un module lumineux de véhicule terrestre selon l'objet du jeu de revendications joint.

On propose également un dispositif lumineux, notamment d'éclairage et/ou de signalisation de préférence de véhicule terrestre, comprenant le module lumineux ci-dessus.

### BREVE DESCRIPTION DES FIGURES

Différents modes de réalisation de l'invention vont maintenant être décrits, à titre d'exemples nullement limitatifs, en se référant aux dessins annexés dans lesquels :
- La FIG. 1 montre schématiquement un dispositif électronique selon l'art antérieur ;
- La FIG. 2 montre schématiquement un exemple de module lumineux selon l'invention ; et
- La FIG. 3 montre schématiquement un exemple de câblage de DELs d'une matrice monolithique selon l'invention.

### DESCRIPTION DETAILLEE

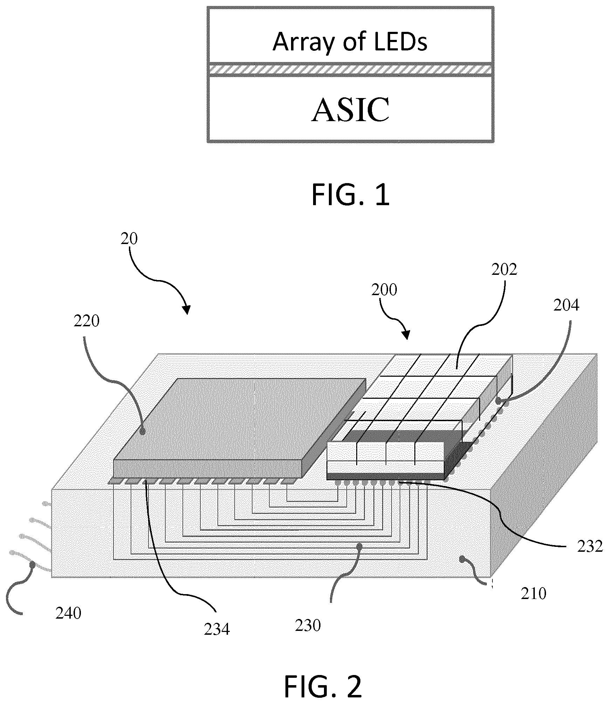

La figure 1 montre un exemple de module lumineux connue dans l'état de la technique sous la terminologie de « stacked ASIC » : la matrice de LEDs repose sur le circuit ASIC permettant son alimentation électrique. L'interface entre la matrice de LEDs et le driver est représentée en hachuré. Cette interface peut comprendre de la colle afin d'assurer que la matrice de LEDs reste en contact avec le driver.

La figure 2 montre un exemple de module lumineux selon l'invention. Le module lumineux peut être un module lumineux de véhicule terrestre. Un ou plusieurs modules lumineux peuvent constituer ou peuvent être intégrés à un projecteur de lumière. Le dispositif lumineux peut être un projecteur avant, un feu arrière ou un appareil lumineux pour l'habitacle. On propose également un véhicule terrestre comprenant une ou plusieurs versions d'un tel dispositif lumineux (par exemple une ou plusieurs paires de versions à l'avant et/ou une ou plusieurs paires de versions à l'arrière pour un véhicule quatre roues, ou une ou plusieurs versions à l'avant et/ou une ou plusieurs versions à l'arrière pour un véhicule deux ou trois roues).

Le module lumineux 20 comprend au moins une source électroluminescente 200 comprenant au moins un élément électroluminescent 202. La source électroluminescente est une source de lumière à état solide (acronyme de l'anglais « solid-state lighting ») qui comprend au moins un élément électroluminescent. L'élément électroluminescent peut être, mais n'est pas limité à, une diode électroluminescente (LED), une diode électroluminescente organique (OLED), une diode électroluminescente polymérique (PLED). La source électroluminescente est donc une lumineuse à semi-conducteur et elle comporte un substrat 204 à partir duquel s'étendent les éléments électroluminescents. Un élément électroluminescent est plus généralement appelé pixel. Par conséquent, le module lumineux comprend au moins une pluralité de pixels déposés sur ou s'étendant à partir de la première face du substrat 204.

Les éléments électroluminescents peuvent être chacun semi-conducteur, c'est-à-dire qu'ils comportent chacun au moins un matériau semi-conducteur. Les éléments électroluminescents peuvent être majoritairement en matériau semi-conducteur. Ce matériau semi-conducteur peut être le même que ou différent du matériau semi-conducteur du substrat. Les éléments électroluminescents peuvent plus généralement être tous réalisés dans le ou les mêmes matériaux. Les éléments électroluminescents peuvent être de même nature, par exemple sensiblement identiques ou similaires. Tous les éléments électroluminescents peuvent être positionnés pour former un motif régulier, par exemple une grille.

Les éléments sont électroluminescents. Cela signifie qu'ils émettent de la lumière lorsque le matériau des éléments électroluminescents est alimenté en électricité. On peut donc parler de pixel lumineux lorsqu'un élément électroluminescent émet de la lumière. Les éléments électroluminescents utilisent l'électroluminescence pour émettre de la lumière. L'électroluminescence est un phénomène optique et électrique durant lequel un matériau émet de la lumière en réponse à un courant électrique qui le traverse, ou à un fort champ électrique. Cela est à distinguer de l'émission de lumière en raison de la température (incandescence) ou de l'action des produits chimiques (chimiluminescence).

Dans un premier exemple, la source électroluminescente est une source électroluminescente monolithique, encore appelée matrice monolithique de LEDs qui est la traduction du terme anglais « monolithic array of LEDs ». Une matrice monolithique comprend des centaines ou des milliers d'élément électroluminescents qui sont situées sur un même substrat 204, et de préférence sur une même face du substrat qui peut être par exemple du saphir. Les DELs de la matrice monolithique sont séparées les unes des autres par des lignes (nommée « lanes » en anglais ou des rues (nommées « streets » en anglais). La matrice monolithique est donc une grille d'éléments électroluminescents ou encore une grille de pixels. Chacun des éléments électroluminescent de la matrice est indépendant électriquement des autres et émet ou non de la lumière indépendamment des autres éléments de la matrice. Chaque élément de la matrice est commandé individuellement par un circuit électronique appelé « driver » en anglais. Alternativement, des éléments électroluminescents peuvent être regroupés électriquement, par exemple en les alimentant électriquement à l'aide d'un montage en parallèle ou en série, afin de diminuer le nombre d'éléments à gérer. Par exemple, les groupes peuvent comprendre entre deux et quatre éléments électroluminescents, ce nombre permettant de conserver un faisceau lumineux suffisamment pixélisé. Le driver gère l'alimentation électrique de la matrice monolithique, ce qui revient à dire qu'il gère individuellement l'alimentation électrique de chaque élément électroluminescent. Le driver est donc un dispositif électronique qui est apte à commander les éléments d'une matrice monolithique d'éléments électroluminescents.

Dans un deuxième exemple non couvert par le jeu de revendications joint, le module lumineux comprend au moins une source électroluminescente à semi-conducteur comportant un substrat 204 majoritairement en matériau semi-conducteur. On peut ainsi faire référence au substrat par l'expression « substrat semi-conducteur ». Le substrat peut comporter un ou plusieurs autres matériaux, par exemple non semi-conducteurs. La source électroluminescente comporte également un ou plusieurs ensembles d'éléments électroluminescents s'étendant à partir d'une première face du substrat. Par conséquent, le module lumineux comprend au moins une pluralité de tels éléments s'étendant à partir de la première face du substrat. Chaque ensemble est constitué de plusieurs éléments s'étendant à partir d'une portion respective de la première face du substrat. Les éléments électroluminescents peuvent donc être répartis dans différentes zones d'émission lumineuse. Dans un exemple, ces différentes zones peuvent être activables sélectivement. Les éléments peuvent présenter une forme générale de bâtonnet et être ainsi appelés « bâtonnets ».

Toujours dans ce deuxième exemple, les éléments électroluminescents peuvent être alimentés en électricité via le substrat d'un côté (e. g. le substrat formant par exemple la cathode) et via une couche de matériau électriquement conducteur qui lie électriquement les éléments électroluminescents entre eux de l'autre côté (e. g. la couche de matériau électriquement conducteur formant par exemple l'anode). Le contact entre le matériau semi-conducteur de chaque élément électroluminescent et le matériau semi-conducteur du substrat peut donc être adapté à une conduction électrique. La couche de matériau électriquement conducteur peut recouvrir les éléments électroluminescents. La couche de matériau électriquement conducteur peut également recouvrir chaque portion de surface du substrat à partir de laquelle les éléments électroluminescents s'étendent, ou toute une surface ou face du substrat à partir de laquelle les ensembles d'éléments électroluminescents s'étendent. La couche de matériau électriquement conducteur peut être isolée électriquement du matériau semi-conducteur du substrat par tout moyen. Cela permet d'alimenter les éléments électroluminescents en électricité par le substrat. Ainsi, on peut alimenter les éléments électroluminescents en électricité simplement, c'est-à-dire en alimentant le matériau conducteur du substrat avec une polarité et la couche de matériau électriquement conducteur avec l'autre polarité.

Toujours dans ce deuxième exemple, la source électroluminescente peut être fabriquée par un procédé comprenant au moins une étape de fourniture du substrat, puis une étape de formation intégrale des bâtonnets avec le substrat, par croissance à partir du substrat. La couche de matériau électriquement conducteur peut être réalisée par une étape de dépose d'une finition métal, par exemple de cuivre pour assurer le pilotage des bâtonnets. Cette étape peut également comprendre la création de pads en aluminium ou cuivre sur une face du substrat, aptes à du câblage par fil entre la source et le composant de pilotage. Le câblage par fil ou « pontage » (également appelé « wirebonding » ou « wire bonding » de l'anglais ou encore ribbon bonding...) est une des techniques utilisées pour effectuer les connexions électriques entre la source électroluminescente et le dispositif d'alimentation de la source. Le câblage est simplement réalisé par un fil (ou pont) soudé entre les deux plots de connexion prévus à cet usage sur chacun des éléments. La soudure peut être réalisée par ultrasons. Le matériau du fil peut être de l'aluminium, de l'or ou du cuivre. Le diamètre du fil peut être de l'ordre de 20 µm. Un fil de section rectangulaire peut aussi être utilisé.

Selon l'invention, la source électroluminescente est une source électroluminescente monolithique, e. g. celle décrite dans le précédent premier exemple. Une source monolithique est une source ayant une forte densité de pixels (ou encore éléments électroluminescents). En pratique, on peut considérer que la source électroluminescente est une source électroluminescente monolithique si la densité de pixels est supérieure ou égale à 400 pixels par centimètre carré (cm²). En d'autre terme, la distance entre le centre d'un premier pixel et le centre d'un deuxième pixel voisin du premier est égale ou inférieur à 500 micromètres (µm) ; cette distance est également appelée « pixel pitch » en anglais.

Le module lumineux selon l'invention comprend un (ou plusieurs) dispositif(s) électronique(s) 220 apte(s) à commander les éléments électroluminescents de la source électroluminescente. Un tel dispositif électronique peut être par exemple un circuit intégré ou un convertisseur de puissance.

Un convertisseur de puissance est un dispositif de conversion d'une alimentation électrique issue d'un réseau d'alimentation électrique du véhicule en une alimentation électrique adaptée à la réalisation d'une fonction lumineuse souhaitée, et éventuellement à fournir ladite alimentation électrique adaptée à une source électroluminescente pour la réalisation de ladite fonction lumineuse souhaitée.

Un circuit intégré, encore appelé puce électronique, est un composant électronique reproduisant une ou plusieurs fonctions électroniques et pouvant intégrer plusieurs types de composants électroniques de base, par exemple dans un volume réduit (i.e. sur une petite plaque). Cela rend le circuit facile à mettre en œuvre.

Le circuit intégré peut être par exemple un ASIC ou un ASSP.

Un ASIC (acronyme de l'anglais « Application-Specific Integrated Circuit ») est un circuit intégré développé pour au moins une application spécifique (c'est-à-dire pour un client). Un ASIC est donc un circuit intégré (micro-électronique) spécialisé. En général, il regroupe un grand nombre de fonctionnalités uniques ou sur mesure.

Un ASSP (acronyme de l'anglais « Application Specific Standard Product ») est un circuit électronique intégré (micro-électronique) regroupant un grand nombre de fonctionnalités pour satisfaire à une application généralement standardisée. Un ASIC est conçu pour un besoin plus particulier (spécifique) qu'un ASSP

L'alimentation en électricité de la source électroluminescente, et donc des éléments électroluminescents est réalisée via le dispositif électronique, lui-même alimenté en électricité à l'aide par exemple d'au moins connecteur le reliant à une source d'électricité. Le dispositif électronique alimente alors les éléments électroluminescents en électricité. Le dispositif électronique est ainsi apte à commander les éléments électroluminescents.

Le module lumineux comprend également un interposeur 210 reliant électriquement la source électroluminescente 200 et le dispositif électronique 220. L'interposeur (traduction littérale du terme anglais « interposer ») est une interface électrique permettant de router l'électricité entre deux connecteurs. En d'autres termes, l'interposeur est un substrat qui permet de connecter entre eux au moins deux connecteurs. Le routage d'une connexion entre deux connecteurs peut être réalisé à l'aide d'une piste conductrice d'électricité. Une piste peut être réalisée sur le substrat de l'interposeur, c'est-à-dire à la surface d'une ou plusieurs faces de l'interposeur. Une piste peut être réalisée au sein du substrat de l'interposeur, c'est-à-dire que la piste est à l'intérieur du substrat de l'interposeur. Une piste peut comprendre une partie sur le substrat et une partie dans le substrat de l'interposeur. L'interposeur peut comporter n'importe qu'elle combinaison des trois types de pistes décrits précédemment. Une piste comprend au moins deux connecteurs situés de part et d'autre de chaque extrémité de la piste et permettant de créer un contact électrique avec un connecteur de la source électroluminescente et un connecteur du dispositif électronique. Sur la figure 2, la piste 230 est réalisée à l'intérieur du substrat de l'interposeur et comprend une première extrémité 232 connectée avec un connecteur d'un élément électroluminescent 202 de la source électroluminescente 200 et une seconde extrémité 234 connectée avec un connecteur de l'ASIC 220 implémentant le driver de la source électroluminescente 200.

Les pistes de l'interposeur sont généralement métalliques car les métaux assurent une bonne conductivité de l'électricité ; par exemple, les pistes sont en cuivre.

L'interposeur comprend un substrat qui offre une isolation électrique entre les différentes pistes qu'il peut comporter. Le(s) matériau(x) composant le substrat de l'interposeur peut être un matériau inorganique et/ou organique.

Les matériaux inorganiques comprennent principalement, mais ne sont pas limités à, les verres synthétiques et naturels, les émaux, les céramiques, les pierres,... De préférence, le substrat de l'interposeur peut comprendre un matériau ou une combinaison de matériaux sélectionnés parmi du silicium, du verre, de la céramique ; le silicium, le verre sont des matériaux intéressants car leurs propriétés physiques permettent d'avoir une densité de piste supérieure à celles qu'offrent d'autres matériaux. Autrement dit, le silicium et le verre permettent d'assurer une isolation électrique entre deux pistes avec une distance entre ces deux pistes qui est inférieure à celle qui serait nécessaire avec un autre matériau telle que la céramique. Le Silicium est le matériau permettant la meilleure dissipation thermique à comparer du verre qui présente l'avantage d'être moins cher.

Les matériaux organiques comprennent, mais ne sont pas limités à, l'époxy, le polyimide tel que celui commercialisé sous la marque Kapton, le silicone.

De manière générale, le substrat formant l'interposeur doit avoir une bonne résistance à la chaleur. L'utilisation de matériaux inorganiques tels que ceux présentés précédemment facilitent la transmettre la chaleur hors du module lumineux.

L'interposeur peut présenter une forme générale de plaque, présentant deux faces opposées. La source électroluminescente et le dispositif électronique peuvent être agencés chacun sur une face différente de l'interposeur, ou bien sur une même face de l'interposeur. Agencé signifie qu'il existe un premier contact entre une face de l'interposeur et la source électroluminescente, et un deuxième contact entre une face de l'interposeur et le dispositif électronique. Le contact est de préférence permanent. Le contact permanent est réalisé par exemple par soudure, par collage, par n'importe quel procédé tels que par exemple « flip chip », « reflow », « copper pillar », « micro tubes », « thermosonic AuSn », « hybrid bonding »,....

Le module lumineux peut en outre comprendre au moins un dissipateur thermique qui est agencé sur au moins une face de l'interposeur. Le dissipateur thermique permet le transfert de la chaleur de la source électroluminescente que cette dernière transmet à l'interposeur lors de l'utilisation d'un module lumineux. La source électroluminescente et la coopération entre le dissipateur thermique et l'interposeur permettent donc d'obtenir un module lumineux de véhicule terrestre simple à réaliser et à monter dans un dispositif lumineux de véhicule, induisant un encombrement relativement faible, compact et présentant une bonne capacité à dissiper de la chaleur.

Le dissipateur thermique permet une dissipation de chaleur via une coopération avec le substrat de l'interposeur, c'est-à-dire que le dissipateur thermique reçoit la chaleur produite par la source électroluminescente. Le dissipateur thermique est ainsi en communication de chaleur avec l'interposeur qui est lui-même en communication de chaleur avec la source électroluminescente.

La transmission peut être assurée par le fait que le dissipateur thermique est dans un exemple agencé directement contre l'interposeur. Cela signifie que le dissipateur thermique est en contact physique (i. e. de matériau) avec l'interposeur.

Le dissipateur thermique peut toutefois être alternativement agencé contre l'interposeur via un élément intermédiaire qui améliore le transfert thermique. L'élément intermédiaire est agencé entre l'interposeur et le dissipateur thermique. L'élément intermédiaire peut comprendre par exemple de la pâte thermique ou un matériau à changement de phase. L'élément intermédiaire peut comprendre du cuivre, par exemple l'élément intermédiaire est une plaque de cuivre. L'élément intermédiaire peut également être une colle qui maintient le dissipateur thermique agencé contre l'interposeur.

La figure 2 montre un exemple dans lequel la source électroluminescente 200 et le dispositif électronique 220 sont agencés sur une même face de l'interposeur 210. Cet agencement est particulièrement intéressant puisqu'il permet d'agencer sur la face opposée de l'interposeur un dissipateur thermique (non représenté sur la figure).

Toujours dans l'exemple de la figure 2, le dispositif électronique comprend un dispositif électronique de commande, étant entendu qu'il pourrait en comprendre plusieurs. Cette électronique peut être configurée pour interagir avec les éléments électroluminescents du module lumineux, par exemple pour commander individuellement l'émission ou non de lumière de chaque élément. On comprend que l'agencement de la figure 2 permet à l'électronique de commande du module lumineux d'être au plus près du dissipateur thermique. Cette électronique générant également de la chaleur, cette solution permet d'optimiser la dissipation de chaleur. En outre, cette solution permet d'améliorer la compacité du module lumineux, en évitant tout d'abord un dispositif électronique de commande séparé du module lumineux et donc la prévision de place supplémentaire et l'ajout de connecteur nécessaire. En effet, dans l'art antérieur tel qu'illustré dans la figure 1, un driver fixé sur le composant d'un module LED induit un auto-échauffement de la LED par le driver, ce qui peut réduire la performance en flux. De même, le driver se trouve auto échauffé par la LED, donc plus sensible thermiquement. Dans l'art antérieur, cela peut conduire à un dimensionnement plus important du dissipateur thermique pour un objectif de refroidissement donné.

Le module lumineux selon l'invention peut en outre comprendre un ou plusieurs composants électroniques passifs, c'est-à-dire des composants électroniques qui n'amplifient pas un signal électrique. Alternativement, le module lumineux selon l'invention peut en outre comprendre un ou plusieurs composants électroniques actifs, c'est-à-dire des composants électroniques qui amplifient un signal électrique. On comprend que le module lumineux peut comprendre à la fois des composants électroniques passifs et actifs. Ces composants électroniques peuvent être par exemple des capacités de protection ESD, des diodes Zener de protection, des résistances de bin. Ces composants peuvent faire partie du schéma électronique de pilotage et de protection de la source électroluminescente. On comprend également que d'autres éléments du module lumineux peuvent comprendre des composants électroniques passifs et/ou actifs ; par exemple le dispositif électronique de commande peut être un composant actif et/ou passif.

Ce(s) composant(s) électronique(s) passif(s) et/ou actif(s) peut être agencé(s) au moins en parti sur une face de l'interposeur ; l'agencement est par exemple réalisé comme précédemment discuté pour la source lumineuse et le dispositif électronique.

Ce(s) composant(s) électronique(s) passif(s) et/ou actif(s) peut être agencé(s) dans l'interposeur, c'est-à-dire qu'il est implémenté au sein du substrat de l'interposeur. En d'autres termes, l'interposeur joue non seulement le rôle de support pour pistes conductrices d'électricité, mais également de composant(s) électronique(s). Par exemple, on peut envisager que l'interposeur puisse servir de substrat 204 pour les éléments électroluminescents de la source électroluminescente. On peut également envisager que l'interposeur puisse implémenter le dispositif électronique apte à commander les éléments électroluminescents.

Le module lumineux peut également comprendre au moins un connecteur électrique 240 agencé sur l'interposeur et relié électriquement au dispositif électronique. Le connecteur permet d'alimenter le module lumineux en électricité lors le connecteur 240 est mis en contact avec une source électrique externe au module lumineux. En pratique, le module lumineux comprend au moins trois connecteurs pour alimenter en courant continu le module lumineux ; par exemple un premier connecteur alimente le module avec une tension positive, un deuxième avec une tension négative, et un troisième apporte une masse. La masse peut faire office de tension basse (0 volt). La présence de connecteurs facilite l'ajout ou le retrait du module lumineux dans un dispositif utilisant ce module lumineux sur le principe d'un SiP (acronyme anglais de « System in Package », système dans un boîtier en français). Par exemple, le module lumineux selon l'invention peut facilement être ajouté par clipsage ou vissage dans un phare de voiture ; de même qu'il peut facilement être retiré et remplacé d'un phare s'il est défectueux.

Les sources électroluminescentes monolithiques ont une forte densité de pixels. L'interposeur du module lumineux selon l'invention offre un substrat via lequel il est possible de relier électriquement la source lumineuse avec le dispositif électronique puisque l'interposeur permet de fournir un nombre de pistes électriques suffisamment élevé pour que chaque élément de la source électroluminescente puisse être commandé par le dispositif électronique. Cependant, afin de réduire le nombre de pistes devant être routées sur l'interposeur, plusieurs éléments électroluminescents de la source électroluminescente peuvent être reliés électriquement en série. Les éléments reliés en série ne nécessitent alors plus qu'une seule alimentation électrique commune, c'est-à-dire qu'une seule piste de l'interposeur est nécessaire pour relier électriquement le dispositif électronique et les éléments électroluminescents reliés électriquement en série. On comprend qu'il est possible de réduire le nombre de pistes devant être « routées » sur l'interposeur lorsque la densité de pixels de la source est trop importante.

Le choix des éléments électroluminescents montés en série peut être un choix arbitraire ; par exemple les éléments de la source sont connectés en série deux à deux. Ce choix peut également dépendre des conditions d'utilisation du module lumineux. Par exemple, si le module lumineux est utilisé comme source d'éclairage et/ou de signalisation d'un véhicule terrestre, seules certaines zones de la source électroluminescente nécessitent une pleine résolution (c'est-à-dire que tous les éléments électroluminescents doivent être commandés individuellement) alors que les autres zones requièrent résolution moindre (c'est-à-dire que les éléments électroluminescents ne doivent pas être commandés individuellement).

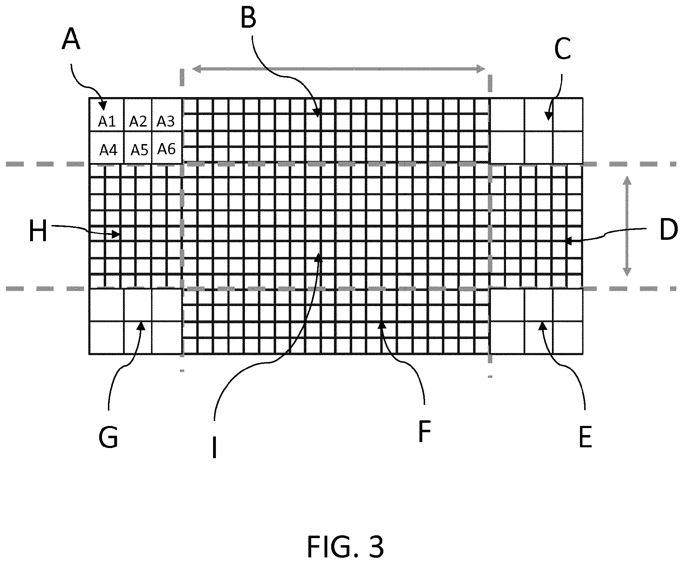

La figure 3 illustre un exemple dans lequel une matrice monolithique de LEDs 200 a été subdivisée en neuf zones. Les zones notées B, D, F, H, I sont des zones dans lesquelles la résolution maximale a été conservée : chaque LED est individuellement commandée par le dispositif électronique 220. Les zones notées A, C, E, G sont des zones dans lesquelles les LEDs ont été sérialisées afin de créer des groupes. Par exemple, la zone A est subdivisée en six groupes A1, A2, A3, A4, A5, et A6, et dans chacun de ces groupes, les LEDs sont montées en série de sorte qu'une seule piste est nécessaire pour les commander. Les zones A, C, E, G sont situés sur les angles de la matrice car l'espace éclairé par ces zones, dans une utilisation du module lumineux comme source d'éclairage d'un véhicule terrestre, ne nécessite pas une haute résolution car en périphérie de la scène éclairée.

## Revendications

1. Module lumineux (20) de véhicule terrestre comprenant :
- une source électroluminescente (200) comprenant au moins un élément électroluminescent (202);
- un dispositif électronique (220) apte à commander l'élément électroluminescent ;
- un interposeur (210) reliant (230, 232, 234) électriquement la source électroluminescente et le dispositif électronique
dans lequel :
- la source électroluminescente et le dispositif électronique sont agencés sur une première face de l'interposeur et le dissipateur thermique est agencé contre une deuxième face de l'interposeur ;
- la source électroluminescente est une matrice monolithique comprenant une pluralité d'éléments électroluminescents ;
- l'interposeur comprend au moins une piste métallique reliant électriquement le dispositif électronique et ledit au moins un élément électroluminescent de la source électroluminescente
**caractérisé en ce que** la source électroluminescente est subdivisée :
• en au moins une zone à résolution maximale (B, D, F, H, I ) dans laquelle chaque élément électroluminescent est relié électriquement avec le dispositif électronique par une piste métallique dans l'interposeur, et
• en au moins une zone à résolution moindre (A, C, E, G) dans laquelle au moins deux éléments électroluminescents sont reliés électriquement en série formant un groupe d'éléments électroluminescents (A1, A2, A3, A4, A5) et l'interposeur comprend une piste métallique reliant électriquement dispositif électronique et ledit groupe d'éléments électroluminescents.

2. Module lumineux selon la revendication 1, dans lequel le dissipateur thermique est agencé contre la face de l'interposeur via un élément intermédiaire qui comprend au moins un parmi :
- une pâte thermique ;
- une couche de cuivre ;
- une colle.

3. Module lumineux selon la revendication 1 ou la revendication 2, dans lequel l'interposeur comprend au moins un parmi :
- un matériau inorganique ;
- un matériau organique.

4. Module selon la revendication 3, dans lequel le matériau inorganique comprend au moins un parmi :
- silicium ;
- verre ;
- céramique.

5. Module lumineux selon l'une des revendications 1 à 4, dans lequel le dispositif électronique comprend au moins un convertisseur de puissance et/ou un circuit intégré.

6. Module lumineux selon l'une des revendications 1 à 5, comprenant en outre un composant électronique passif et/ou actif.

7. Module lumineux selon la revendication 6, dans lequel le composant électronique est agencé sur et/ou dans l'interposeur.

8. Module lumineux selon l'une des revendications 1 à 7, comprenant au moins un connecteur électrique (240) agencé sur l'interposeur et relié électriquement un dispositif électronique.

9. Module lumineux selon l'une des revendications 1 à 8, dans lequel ladite au moins une zone à résolution moindre est située sur un angle de la matrice monolithique d'éléments électroluminescents.

10. Dispositif lumineux, notamment d'éclairage et/ou de signalisation de préférence de véhicule terrestre, comprenant un module lumineux selon l'une des revendications 1-9.

## Patentansprüche

1. Leuchtmodul (20) für ein terrestrisches Fahrzeug, umfassend:
- eine Elektrolumineszenzquelle (200) mit mindestens einem Elektrolumineszenzelement (202);
- eine elektronische Vorrichtung (220) zur Steuerung des elektrolumineszenten Elements;
- einen Zwischenverbinder (210), der die Elektrolumineszenzquelle und die elektronische Vorrichtung elektrisch verbindet (230, 232, 234),
wobei:
- die Elektrolumineszenzquelle und die elektronische Vorrichtung auf einer ersten Fläche des Zwischenelements angeordnet sind und der Wärmeableiter an einer zweiten Fläche des Zwischenelements angeordnet ist;
- die elektrolumineszente Quelle eine monolithische Anordnung von Leuchtdioden ist;
- der Zwischenverbinder mindestens eine Metallbahn umfasst, die die elektronische Vorrichtung und das mindestens eine elektrolumineszente Element der elektrolumineszenten Quelle elektrisch verbindet
**dadurch gekennzeichnet, dass** die Elektrolumineszenzquelle unterteilt ist:
• in mindestens einen Bereich maximaler Auflösung (B, D, F, H, I), in dem jedes elektrolumineszente Element über eine metallische Leiterbahn innerhalb des Zwischenelements elektrisch mit der elektronischen Vorrichtung verbunden ist; und
• in mindestens einen Bereich geringerer Auflösung (A, C, E, G), in dem mindestens zwei elektrolumineszente Elemente elektrisch in Reihe geschaltet sind und eine Gruppe von elektrolumineszenten Elementen (A1, A2, A3, A4, A5) bilden, und der Zwischenverbinder eine metallische Leiterbahn umfasst, die die elektronische Vorrichtung und die Gruppe von elektrolumineszenten Elementen elektrisch verbindet.

2. Leuchtmodul nach Anspruch 1, wobei der Wärmeableit t oder über ein Zwischenelement, das mindestens eines der folgenden Elemente umfasst, an der Oberfläche des Interposers angeordnet ist:
- einer Wärmeleitpaste;
- eine Kupferschicht;
- einem Klebstoff.

3. Leuchtmodul nach Anspruch 1 oder Anspruch 2, wobei der Zwischenkörper mindestens eines der folgenden Elemente umfasst:
- einem anorganischen Material;
- ein organisches Material.

4. Modul gemäß Anspruch 3, wobei das anorganische Material mindestens eines der folgenden Elemente umfasst:
- Silizium;
- Glas;
- Keramik.

5. Leuchtmodul nach einem der Ansprüche 1 bis 4, wobei die elektronische Vorrichtung mindestens einen Leistungswandler und/oder eine integrierte Schaltung umfasst.

6. Leuchtmodul nach einem der Ansprüche 1 bis 5, das zusätzlich eine passive und/oder aktive elektronische Komponente umfasst.

7. Leuchtmodul nach Anspruch 6, wobei die elektronische Komponente auf und/oder in dem Interposer angeordnet ist.

8. Leuchtmodul nach einem der Ansprüche 1 bis 7, das mindestens einen elektrischen Verbinder (240) umfasst, der auf dem Interposer angeordnet und elektrisch mit der elektronischen Vorrichtung verbunden ist.

9. Leuchtmodul nach einem der Ansprüche 1 bis 8, wobei die mindestens eine Zone mit geringerer Auflösung an einer Ecke der monolithischen Anordnung von Elektrolumineszenz-Elementen angeordnet ist.

10. Beleuchtungsvorrichtung, insbesondere eine Beleuchtungs- und/oder Signalisierungsvorrichtung, vorzugsweise für ein Landfahrzeug, mit einem Beleuchtungselement gemäß einem der Ansprüche 1 bis 9.

## Claims

1. Luminous module (20) for a terrestrial vehicle comprising:
- an electroluminescent source (200) comprising at least one electroluminescent element (202);
- an electronic device (220) designed to control the electroluminescent element;
- an interposer (210) electrically connecting (230, 232, 234) the electroluminescent source and the electronic device,
wherein:
- the electroluminescent source and the electronic device are arranged on a first face of the interposer and the heat dissipator is arranged against a second face of the interposer;
- the electroluminescent source is a monolithic array of light-emitting diodes;
- the interposer comprises at least one metal track electrically connecting the electronic device and the said at least one electroluminescent element of the electroluminescent source
**characterized in that** the electroluminescent source is subdivided:
• in at least one area of maximum resolution (B, D, F, H, I) in which each electroluminescent element is electrically connected to the electronic device by a metallic trace within the interposer; and
• in at least one area of lower resolution (A, C, E, G) in which at least two electroluminescent elements are electrically connected in series, forming a group of electroluminescent elements (A1, A2, A3, A4, A5), and the interposer includes a metallic track electrically connecting the electronic device and said group of electroluminescent elements.

2. Luminous module according to claim 1, in which the heat dissipator is arranged against the face of the interposer via an intermediate element which comprises at least one from amongst:
- a thermal paste;
- a layer of copper;
- an adhesive.

3. Luminous module according to claim 1 or claim 2, in which the interposer comprises at least one from between:
- an inorganic material;
- an organic material.

4. Module according to Claim 3, in which the inorganic material comprises at least one from amongst:
- silicon;
- glass;
- ceramic.

5. Luminous module according to one of Claims 1 to 4, in which the electronic device comprises at least one power converter and/or one integrated circuit.

6. Luminous module according to one of Claims 1 to 5, furthermore comprising a passive and/or active electronic component.

7. Luminous module according to Claim 6, in which the electronic component is arranged on and/or in the interposer.

8. Luminous module according to one of Claims 1 to 7, comprising at least one electrical connector (240) arranged on the interposer and electrically connected to the electronic device.

9. Luminous module according to any one of claims 1 to 8, in which said at least one lower resolution zone is located on a corner of the monolithic array of electroluminescent elements.

10. Lighting device, notably a lighting and/or signalling device, preferably for a terrestrial vehicle, comprising a lighting element according to one of Claims 1-9.
